Europäisches Patentamt

European Patent Office

Office européen des brevets

(19)

(11) Veröffentlichungsnummer: **0 009 192**
**B1**

(12) **EUROPÄISCHE PATENTSCHRIFT**

(45) Veröffentlichungstag der Patentschrift:
**20.01.82**

(21) Anmeldenummer: **79103358.2**

(22) Anmeldetag: **07.09.79**

(51) Int. Cl.³: **G 01 R 31/28,** H 03 K 21/30,
H 03 K 21/36

(54) Schaltungsanordnung zur Erzeugung einer Abtastimpulsfolge für ein periodisches Signal.

(30) Priorität: **14.09.78 DE 2840065**

(43) Veröffentlichungstag der Anmeldung:
**02.04.80 Patentblatt 80/7**

(45) Bekanntmachung des Hinweises auf die Patenterteilung:
**20.01.82 Patentblatt 82/3**

(84) Benannte Vertragsstaaten:
**FR GB**

(56) Entgegenhaltungen:
**DE-A-2 316 634**
**DE-B-1 265 209**
**US-A-3 657 658**
**US-A-3 678 398**

(73) Patentinhaber: **SIEMENS AKTIENGESELLSCHAFT Berlin
und München, Postfach 22 02 61, D-8000 München 22 (DE)**

(72) Erfinder: **Bayati, Abutorab, Dr., Ettlinger Strasse 15,
D-7500 Karlsruhe (DE)**

Schaltungsanordnung zur Erzeugung einer
Abtastimpulsfolge für ein periodisches Signal

Die Erfindung bezieht sich auf eine Schaltungsanordnung zur Erzeugung einer Abtastimpulsfolge für ein periodisches Signal.

Ein Bedarf für derartige Schaltungsanordnungen besteht beispielsweise bei Prüfeinrichtungen, bei denen ein Prüfling ein periodisches Signal abgibt, das mit einem gespeicherten Sollwertsignal verglichen wird, wobei die Abweichung zwischen beiden dargestellt und verarbeitet wird.

Eine Grundvoraussetzung für den Vergleich der beiden Signale ist, dass das gespeicherte Signal synchron mit dem periodischen Signal gelesen werden muss. Zu diesem Zweck werden Abtastimpulse benötigt, mit denen die Adressen des gespeicherten Signals angesteuert und gleichzeitig das periodische Signal abgetastet werden. Die Frequenz der Abtastimpulsfolge muss dazu ein Vielfaches der Frequenz des periodischen Signals sein.

Der Erfindung lag die Aufgabe zugrunde, eine Schaltungsanordnung zur Erzeugung einer Abtastimpulsfolge für ein periodisches Signal mit digitalen Schalteinheiten zu schaffen. Die Lösung dieser Aufgabe ist gemäss der Erfindung dadurch gekennzeichnet, dass der Ausgang eines Taktimpulsgenerators mit Eingängen zweier Frequenzuntersetzer verbunden ist, deren erster mit der Zahl der über die Periode des Signals gleichmässig verteilten Abtaststellen untersetzt und deren zweiter, an seinem Ausgang die Abtastimpulsfolge liefernde Frequenzuntersetzer mit der Zahl der während einer Periode des Signals in einem Zähler aufgelaufenen Ausgangsimpulse des ersten Untersetzers untersetzt ist, wobei zur Vorgabe der Periode eine mit dem periodischen Signal beaufschlagte Triggerschaltung vorgesehen ist.

Zweckmässig sind die Frequenzuntersetzer voreinstellbare Rückwärtszähler.

Bei einem Ausführungsbeispiel der Erfindung sind Bitausgänge des Zählers mit Biteingängen eines Zwischenspeichers und Bitausgänge des Zwischenspeichers mit Setzeingängen des zweiten Frequenzuntersetzers verbunden. Weiter ist beim Ausführungsbeispiel ein Rücksetzeingang des Zählers und ein Übernahmesteuereingang des Zwischenspeichers vom Ausgangssignal der Triggerschaltung angesteuert.

Ein Ausführungsbeispiel der Erfindung wird anhand einer Figur erläutert.

Der Ausgang eines Taktimpulsgenerators TG ist mit den Zähleingängen eines ersten Rückwärtszählers Z1 und eines zweiten Rückwärtszählers Z2 verbunden. Der Rückwärtszähler Z1 ist mit einer Zahl b voreinstellbar, die der Anzahl der Adressen des gespeicherten Sollwertsignals und der Anzahl der über die Periode des periodischen Signals verteilten Abtaststellen entspricht. Ein Übertragungsausgang des Rückwärtszählers Z1 ist mit dem Zähleingang eines Vorwärtszählers Z3 verbunden. Bitausgänge des Zählers Z3 liegen an Biteingängen eines Zwischenspeichers ZP. Bitausgänge des Zwischenspeichers ZP sind mit Setzeingängen des zweiten Rückwärtszählers Z2 verbunden, d.h., der Rückwärtszähler Z2 ist mit der im Zwischenspeicher ZP gespeicherten Zahl voreinstellbar. Das abzutastende periodische Signal liegt am Eingang einer Triggerschaltung TRG. Der Ausgang der Triggerschaltung TRG, an der ein Triggersignal anfällt, ist mit einem Rücksetzeingang des Vorwärtszählers Z3 verbunden. Ebenso steht ein Übernahmesteuereingang des Zwischenspeichers ZP mit dem Ausgang der Triggerschaltung TRG in Verbindung. Das Triggersignal ist auch an eine Abnahmeklemme angelegt.

Der Rückwärtszähler Z1 wird mit der Anzahl b der gespeicherten Signalwerte programmiert. Wenn die Frequenz der aus dem Taktimpulsgenerator TG entnommenen Taktimpulsfolge f ist, ergibt sich für die Überlaufimpulse des Rückwärtszählers Z1 eine Folgefrequenz von $\dfrac{f}{b}$ . Diese Überlaufimpulse werden vom Vorwärtszähler Z3 gezählt, und zwar während der Periodendauer T, die in der Triggerschaltung TRG ermittelt wird. Der Triggerimpuls aus der Triggerschaltung TRG kann bezüglich seiner Lage innerhalb einer Periode des periodischen Signals kontinuierlich verändert werden. Der Inhalt des Zählers Z3 für jede Periode wird, gesteuert vom Triggerimpuls, in den Zwischenspeicher ZP übernommen. Danach wird der Zähler Z3 gelöscht. Über den Zwischenspeicher ZP wird der Rückwärtszähler Z2 mit einer Zahl voreingestellt, die der Signalperiode direkt proportional ist. Diese Zahl ist $T \cdot \dfrac{f}{b}$ . Danach ist die Frequenz der Abtastimpulsfolge, die am Ausgang des zweiten Rückwärtszählers Z2 anfällt,

$$f : (T \cdot \frac{f}{b}) = \frac{b}{T} = b \cdot F,$$ wobei F die Grundfrequenz des periodischen Signals ist. Die Folgefrequenz f der Taktimpulse sollte wesentlich grösser als b $\cdot$ F sein. Z. B. bei einer geforderten Genauigkeit von $\geqq$ 1% muss f $\geqq$ 100 $\cdot$ b $\cdot$ F sein.

Nach dem synchronen Lesen der gespeicherten Kurve kann ein Vergleich mit dem periodischen Signal durchgeführt werden. Dabei kann durch die Einstellung der Triggerung eine zeitliche Verschiebung des gespeicherten Signals erreicht werden.

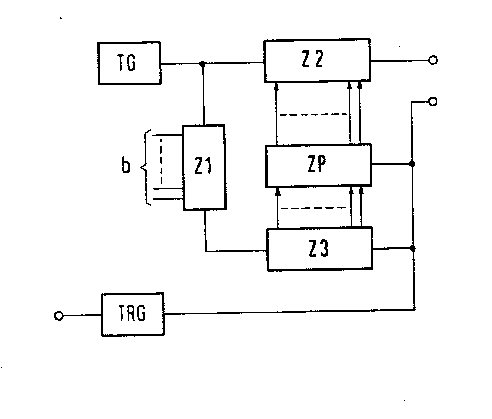

**Patentansprüche**

1. Schaltungsanordnung zur Erzeugung einer Abtastimpulsfolge für ein periodisches Signal, dadurch gekennzeichnet, dass der Ausgang eines Taktimpulsgenerators (TG) mit Eingängen zweier Frequenzuntersetzer (Z1, Z2) verbunden ist, deren erster (Z1) mit der Zahl (b) der über die Periode (T) des Signals gleichmässig verteilten Abtaststellen untersetzt und deren zweiter, an seinem Ausgang die Abtastimpulsfolge liefernde Frequenzuntersetzer (Z2) mit der Zahl der während einer Periode (T) des Signals in einem Zähler (Z3) aufgelaufenen Ausgangsimpulse des ersten Untersetzers (Z1) untersetzt ist, wobei zur Vorgabe der Periode (T) eine mit dem periodischen Signal beaufschlagte Triggerschaltung (TRG) vorgesehen ist.

2. Schaltungsanordnung nach Anspruch 1, dadurch gekennzeichnet, dass die Frequenzuntersetzer (Z1 und Z2) voreinstellbare Rückwärtszähler sind.

3. Schaltungsanordnung nach Anspruch 1 oder 2, dadurch gekennzeichnet, dass Bitausgänge des Zählers (Z3) mit Biteingängen eines Zwischenspeichers (ZP) und Bitausgänge des Zwischenspeichers (ZP) mit Setzeingängen des zweiten Frequenzuntersetzers (Z2) verbunden sind, und dass ein Rücksetzeingang des Zählers (Z3) und ein Übernahmesteuereingang des Zwischenspeichers (ZP) vom Ausgangssignal der Triggerschaltung (TRG) angesteuert sind.

4. Schaltungsanordnung nach Anspruch 3, dadurch gekennzeichnet, dass das Ausgangssignal der Triggerschaltung (TRG) über die Periode (T) des periodischen Signals verschiebbar ist.

**Revendications**

1. Montage pour produire un train d'impulsions de balayage pour un signal périodique, caractérisé par le fait que la sortie d'un générateur d'impulsions de cadence (TG) est reliée à des sorties de deux diviseurs de fréquence (Z1, Z2) dont le premier (Z1) divise par le nombre (b) des points de balayage distribués uniformément sur la période (T) du signal et dont le second divise, à sa sortie le diviseur de fréquence (T2) fournissant le train d'impulsions de balayage par le nombre d'impulsions du premier diviseur (Z1) qui ont été introduites dans un compteur (Z3) pendant une période (T) du signal, un circuit de déclenchement (TRG) chargé du signal périodique étant prévu pour donner à l'avance la période (T).

2. Montage selon la revendication 1, caractérisé par le fait que les diviseurs de fréquence (Z1 et Z2) sont des compteurs dégressifs réglables à l'avance.

3. Montage selon la revendication 1 ou 2, caractérisé par le fait que les sorties de bits du compteur (Z3) sont reliées à des entrées de bits d'une mémoire intermédiaire (ZP) et des sorties de bits de la mémoire intermédiaire (ZP) sont reliées à des entrées d'activation du second diviseur de fréquence (Z2), et qu'une entrée de remise à l'état initial du compteur (Z3) et une entrée de commande de la prise en charge de la mémoire intermédiaire (ZP) sont attaquées par le signal de sortie du circuit de déclenchement.

4. Montage selon la revendication 3, caractérisé par le fait que le signal de sortie du circuit de déclenchement (TRG) peut être décalé sur la période (T) du signal périodique.

**Claims**

1. A circuit arrangement for the production of a sampling pulse sequence for a periodic signal, characterised in that the output of a clock pulse generator (TG) is connected to inputs of two frequency dividers (Z1, Z2), whose first frequency divider (Z1) reduces in accordance with the number (b) of the sampling points which are evenly distributed over the period (T) of the signal, and whose second frequency divider (Z2) which supplies the sampling pulse sequence at its output reduces in accordance with the number of the output pulses, which have accumulated in a counter (Z3) during a period (T) of the signal of the first divider (Z1), where a trigger circuit (TRG) fed with the periodic signal is provided to predetermine the period (T).

2. A circuit arrangement as claimed in claim 1, characterised in that the frequency dividers (Z1 and Z2) are pre-adjustable backward counters.

3. A circuit arrangement as claimed in claim 1 or claim 2, characterised in that bit outputs of the counters (Z3) are connected to bit inputs of an intermediate store (ZP) and bit outputs of the intermediate store (ZP) are connected to setting inputs of the second frequency divider (Z2), and that a resetting input of the counter (Z3) and a transfer control input of the intermediate store (ZP) are activated by the output signal of the trigger circuit (TRG).

4. A circuit arrangement as claimed in claim 3, characterised in that the output signal of the trigger circuit (TRG) is displaceable over the period (T) of the periodic signal.

1/(

TG

Z2

b { Z1

ZP

Z3

TRG